## Europäisches Patentamt
## European Patent Office
## Office européen des brevets

(19)

(11) Numéro de publication : **0 147 307**
**B1**

(12)
# FASCICULE DE BREVET EUROPÉEN

(45) Date de publication du fascicule du brevet :
04.05.88

(51) Int. Cl.⁴ : **H 03 L 7/18**

(21) Numéro de dépôt : 84402638.5

(22) Date de dépôt : 18.12.84

(54) Synthétiseur de fréquences à division fractionnaire, à faible gigue de phase et utilisation de ce synthétiseur.

(30) Priorité : 27.12.83 FR 8320844

(43) Date de publication de la demande :
03.07.85 Bulletin 85/27

(45) Mention de la délivrance du brevet :
04.05.88 Bulletin 88/18

(84) Etats contractants désignés :
DE GB IT

(56) Documents cités :
EP-A- 0 073 699
TELECOMMUNICATIONS & RADIO ENGINEERING,
vol. 35/36, no. 12, décembre 1981, pages 93-95, Silver-
Spring, Maryland, US; V.I. KOZLOV: "A digital phase
detector circuit"

(73) Titulaire : THOMSON-CSF
173, Boulevard Haussmann
F-75379 Paris Cédex 08 (FR)

(72) Inventeur : Roullet, André
THOMSON-CSF, SCPI-173 bld Haussmann
F-75379 Paris Cedex 08 (FR)
Inventeur : Molina, Jacques
THOMSON-CSF SCPI 173 bld Haussmann
F-75379 Paris Cedex 08 (FR)

(74) Mandataire : Turlèque, Clotilde
THOMSON-CSF SCPI 19, avenue de Messine
F-75008 Paris (FR)

EP 0 147 307 B1

**Description**

L'invention concerne un synthétiseur de fréquences mettant en œuvre un procédé de division fractionnaire pour générer des fréquences de diverses valeurs avec un pas très fin et une faible gigue de phase.

Un synthétiseur numérique à division entière comprend un oscillateur asservi commandé par une tension fournie par un comparateur de phase recevant un signal de référence et un signal obtenu en divisant par un diviseur à rang variable la fréquence de l'oscillateur asservi. Le rang de ce diviseur est fixé. La valeur de la fréquence synthétisée est réglable en changeant ce rang, mais ce réglage ne peut être fait que par pas égaux à la fréquence du signal de référence.

Le procédé de division à rang fractionnaire permet d'obtenir une fréquence synthétisée dont la valeur est intermédiaire entre les valeurs correspondant à deux rangs entiers et consécutifs de la division par le diviseur à rang variable, en faisant fonctionner ce diviseur alternativement à ces deux rangs. Lorsque la fréquence synthétisée a une telle valeur, le comparateur de phase fournit un signal non nul, périodique, traduisant le glissement de la phase du signal de l'oscillateur asservi par rapport à la phase du signal de référence. Ce signal périodique est impropre à commander directement l'oscillateur asservi. Il est additionné à un signal, dit de compensation, puis filtré afin d'obtenir un signal de commande de l'oscillateur ayant une valeur constante en régime établi.

Le signal de compensation est généré par un dispositif numérique, appelé accumulateur de phase, et un dispositif de conversion numérique-analogique et de correction. La correction consiste à rendre le signal de compensation proportionnel à la période $1/F_S$, comme l'est le signal fourni par le comparateur de phase. En régime établi, et dans le cas d'un fonctionnement idéal, le signal de commande de l'oscillateur a une valeur constante, la fréquence fournie par l'oscillateur asservi est parfaitement stable, et sa pureté spectrale est parfaite. En pratique, la pureté spectrale n'est pas parfaite car il subsiste des raies de gigue de phase dues à une compensation imparfaite.

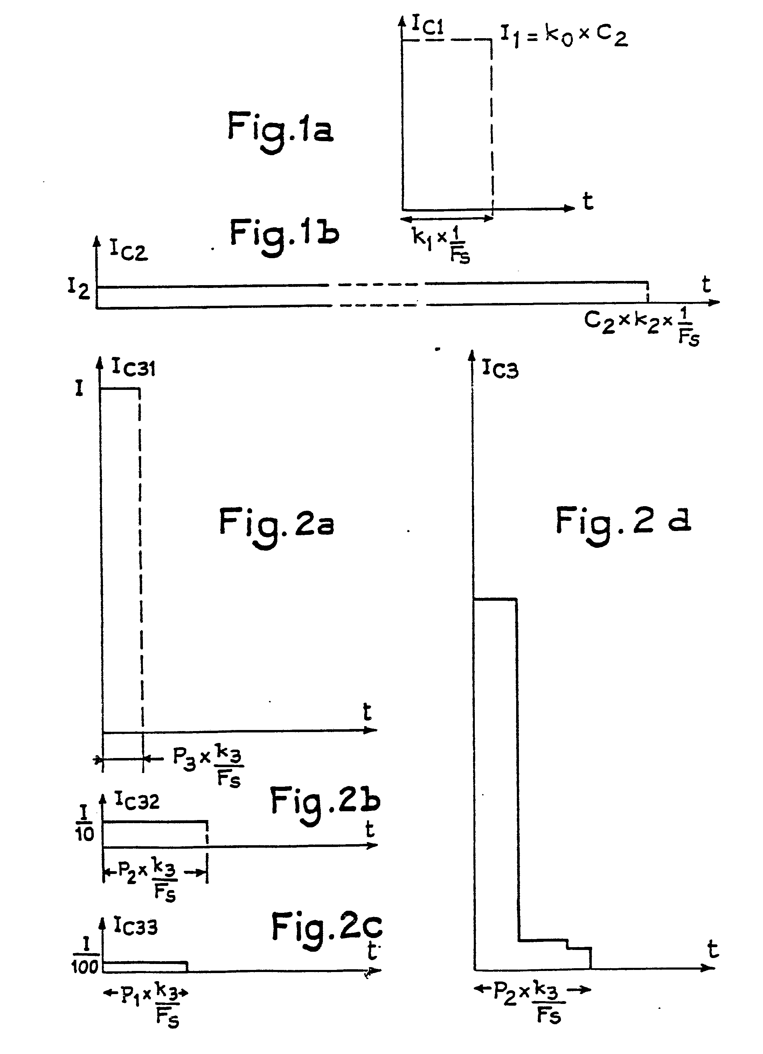

Un tel synthétiseur à division fractionnaire est décrit dans la demande de brevet EP-A-0 073 699 au nom de la Demanderesse. Il comporte un comparateur de phase fournissant un courant d'intensité fixée pendant un intervalle de temps dont la durée est proportionnelle à la différence de phase et à la période $1/F_S$ du signal fourni par l'oscillateur asservi ; il comporte un compteur, dit accumulateur de phase, qui est incrémenté, d'une valeur constante, à la fréquence $F_R$ du signal de référence, et une sortie de ce compteur commande une augmentation d'une unité du rang du diviseur pendant les périodes où le contenu de ce compteur passe par sa valeur maximale ; ce synthétiseur comporte en outre un dispositif de conversion numérique-analogique et de correction, constitué d'un convertisseur numérique-analogique commandé par le signal fourni par l'oscillateur asservi, pour fournir un courant $I_{C1}$ ayant une intensité $I_1$ constante pendant un intervalle de temps déterminé, et une intensité nulle le reste du temps (voir Fig. 1).

L'intensité $I_1 = k_0 \times C_2$ est proportionnelle à une valeur $C_2$ fournie par l'accumulateur de phase, $k_0$ étant une constante. La durée de l'intervalle de temps est égale à $k_1 \times 1/F_S$, où $k_1$ est une constante, pour qu'elle soit proportionnelle à la période $1/F_S$. Cette durée ne dépend pas du contenu de l'accumulateur de phase.

Les courants fournis par le comparateur de phase et par le dispositif de conversion et de correction sont intégrés en fonction du temps par un intégrateur. Pendant chaque période du signal de référence la compensation est réalisée en apportant par le courant de compensation une quantité de charges neutralisant la quantité de charges apportée par le courant fourni par le comparateur de phase. Quand ces deux courants sont redevenus nuls la tension de sortie de l'intégrateur est échantillonnée, mémorisée, filtrée, et constitue la tension de commande de l'oscillateur asservi.

Ce dispositif a pour inconvénient qu'il ne peut être employé que dans des synthétiseurs où le pas de variation de la fréquence synthétisée est relativement grand. En effet ce pas est inversement proportionnel au modulo M de l'accumulateur de phase, et ce modulo détermine le nombre de bits du convertisseur numérique-analogique. La technologie actuelle des convertisseurs numériques-analogiques limite actuellement ce nombre de bits à 16 bits en code binaire, ou à 4 chiffres décimaux codés en binaire. Ces convertisseurs à haute résolution sont lents (temps d'établissement supérieur à 5 microsecondes) et onéreux. Si, par exemple le modulo de l'accumulateur de phase est égal à M = 10 000 et si la valeur fournie par l'accumulateur de phase est représentée par 4 chiffres décimaux codés en binaire, le convertisseur doit comporter 16 bits d'entrée, et, si la période du signal de référence est d'une microseconde, le temps d'établissement doit être très inférieur à une microseconde. Cette performance n'est pas possible en l'état actuel de la technologie des convertisseurs numériques-analogiques, ce qui conduit à augmenter la valeur du pas ou à réduire la vitesse de variation de la fréquence synthétisée.

Un autre dispositif de conversion numérique-analogique et de correction, ne comportant pas de convertisseur numérique-analogique, peut être constitué par une source de courant, d'intensité $I_2$ fixe, en série avec un commutateur commandé par un temporisateur fournissant un signal de durée variable $C_2 \times k_2 \times 1/F_S$ proportionnelle à la valeur $C_2$ fournie par l'accumulateur de phase et proportionnelle à la période $1/F_S$, $k_2$ étant une constante. Cette solution est simple et elle peut être mise en œuvre dans un synthétiseur ayant un pas très fin puisque la valeur M du modulo de l'accumulateur de phase peut être aussi grande que nécessaire, sans limitation due à la technologie des convertisseurs numériques-analogiques. Par contre, la durée $C_2 \times k_2 \times 1/F_S$ du signal de compensation $I_{C2}$ obtenu peut aller jusqu'à $M - 1$ périodes $k_2 \times 1/F_S$ du signal d'horloge du temporisateur, et M étant de valeur élevée lorsque le pas est très fin, cette durée devient trop importante car elle excède la durée de la période de référence qui est particulièrement faible dans le cas où le synthétiseur doit permettre des variations de fréquence rapide. Par exemple si M = 10 000, et si la fréquence d'horloge du temporisateur est de l'ordre de 30 MHz, la durée maximale du signal de compensation est de 333 microsecondes et est incompatible avec la période du signal de référence si celle-ci a une valeur de l'ordre de 1 microseconde. Il n'est pas possible d'utiliser une intensité $I_2$ élevée pour gagner du temps car, pour les faibles valeurs de $C_2$, la durée de passage du courant doit alors être tellement faible qu'il est impossible de réaliser une commutation. Ce dispositif ne permet donc pas des variations rapides de la fréquence synthétisée.

L'objet de l'invention est un synthétiseur à division fractionnaire qui ne présente pas les inconvénients des deux types de synthétiseurs sus-mentionnés et qui, en particulier, comporte un dispositif de conversion numérique-analogique et de correction fournissant un signal de compensation tel que la gigue de phase du signal synthétisé soit très faible, tout en permettant une grande rapidité de variation et une grande résolution de la fréquence synthétisée. Pour cela le signal de compensation, $I_{C3}$, a, à la fois, une intensité et une durée fonctions de la valeur fournie par un accumulateur de phase.

Un autre objet de l'invention consiste en l'utilisation d'un synthétiseur de fréquences à division fractionnaire, à faible gigue de phase, dans un récepteur radio de surveillance.

Si, par exemple, l'accumulateur de phase fournit une valeur décimale codée en binaire par trois mots de valeurs : $P_1$, $P_2$, $P_3$, le courant de compensation $I_{C3}$ est constitué de la somme de trois courants $I_{C31}$, $I_{C32}$, $I_{C33}$, d'intensités fixées : $I$, $I/10$, $I/100$, dont les durées sont égales respectivement à $P_3 \times k_3/F_S$, $P_2 \times k_3/F_S$, $P_1 \times k_3/F_S$, où $k_3$ est une constante. Le courant $I_{C3}$ a ainsi une intensité variable au cours de l'intervalle de temps où il est fourni à un intégrateur, et cet intervalle de temps a une durée variable en fonction du contenu $P_1, P_2, P_3$ de l'accumulateur et en fonction de la fréquence synthétisée $F_S$ (voir Fig. 2).

Les intensités $I$, $I/10$, $I/100$, étant fixées il n'y a pas les problèmes de réalisation rencontrés avec les convertisseurs numériques-analogiques. D'autre part, lorsque le contenu de l'accumulateur de phase a une valeur élevée, la valeur de plus grand poids, $P_3$, est non nulle, un courant d'intensité $I$ relativement élevée, est généré. Une quantité de charge importante est donc apportée par le courant de compensation à l'intégrateur, en un temps beaucoup plus court que par le procédé où le courant de compensation a une intensité $I_{C2}$ fixe, et de faible valeur. La période du signal de référence peut donc être courte, et permettre des variations rapides de la fréquence synthétisée.

Selon l'invention, un synthétiseur de fréquences à division fractionnaire, à faible gigue de phase, comportant :
— un oscillateur asservi fournissant un signal de période $1/F_S$ ;
— un premier additionneur analogique ayant une sortie couplée à une entrée de commande de l'oscillateur ;
— un diviseur de fréquence à rang variable RV, fournissant un signal de fréquence $F_S/RV$ ;
— des moyens pour fournir un signal de référence ;
— un compteur modulo M, dit accumulateur de phase, fournissant un mot binaire C dont la valeur, modulo M, croît d'une valeur k.M à chaque période du signal de référence, k étant compris entre 0 et 1 ;
— un dispositif de conversion numérique-analogique et de correction, couplant une première sortie de l'accumulateur de phase à une première entrée du premier additionneur ;
— un comparateur de phase recevant le signal fourni par le diviseur et le signal de référence, et fournissant à une seconde entrée du premier additionneur un signal analogique dont la valeur est proportionnelle à l'écart de phase entre ces deux signaux et proportionnelle à la période $1/F_S$ ;
est caractérisé en ce que le dispositif de conversion numérique-analogique et de correction comporte :
— une pluralité de dispositifs de temporisation, chacun réalisant une temporisation de durée proportionnelle à la valeur d'une fraction déterminée du mot binaire C et proportionnelle à la période $1/F_S$ ;
— une pluralité de sources fournissant chacune un signal analogique dont la valeur est constante et correspond respectivement au poids d'une des fractions du mot binaire C ;
— un second additionneur analogique ayant une sortie couplée à la première entrée du premier additionneur analogique ;
— une pluralité de commutateurs analogiques reliant respectivement les sources à des entrées du second additionneur et étant commandées respectivement par les dispositifs de temporisation.

L'invention sera mieux comprise et d'autres détails apparaîtront à l'aide de la description ci-dessous et des figures l'accompagnant :
les figures 1a et 1b représentent les graphes des courants $I_{C1}$ et $I_{C2}$ en fonction du temps, courants qui sont fournis respectivement par les deux dispositifs de conversion numérique-analogique et de correction de l'art antérieur mentionnée ci-dessus ;
les figures 2a à 2c représentent les graphes, en fonction du temps, des courants $I_{C31}$, $I_{C32}$, $I_{C33}$, composant le courant $I_{C3}$ fourni par le dispositif de conversion numérique-analogique et de correction de l'exemple de réalisation du synthétiseur selon l'invention mentionnée ci-dessus ;

3

la figure 2d représente le graphe, en fonction du temps, de ce courant l$_{C3}$ ;

la figure 3 représente un schéma synoptique d'un autre exemple de réalisation du synthétiseur selon l'invention ;

les figures 4 et 5 représentent des schémas synoptiques plus détaillés de deux parties de cet autre exemple de réalisation ;

les figures 6 à 8 représentent des diagrammes temporels illustrant le fonctionnement de cet autre exemple de réalisation ;

la figure 9 représente un diagramme temporel illustrant le fonctionnement d'une variante de réalisation du synthétiseur selon l'invention.

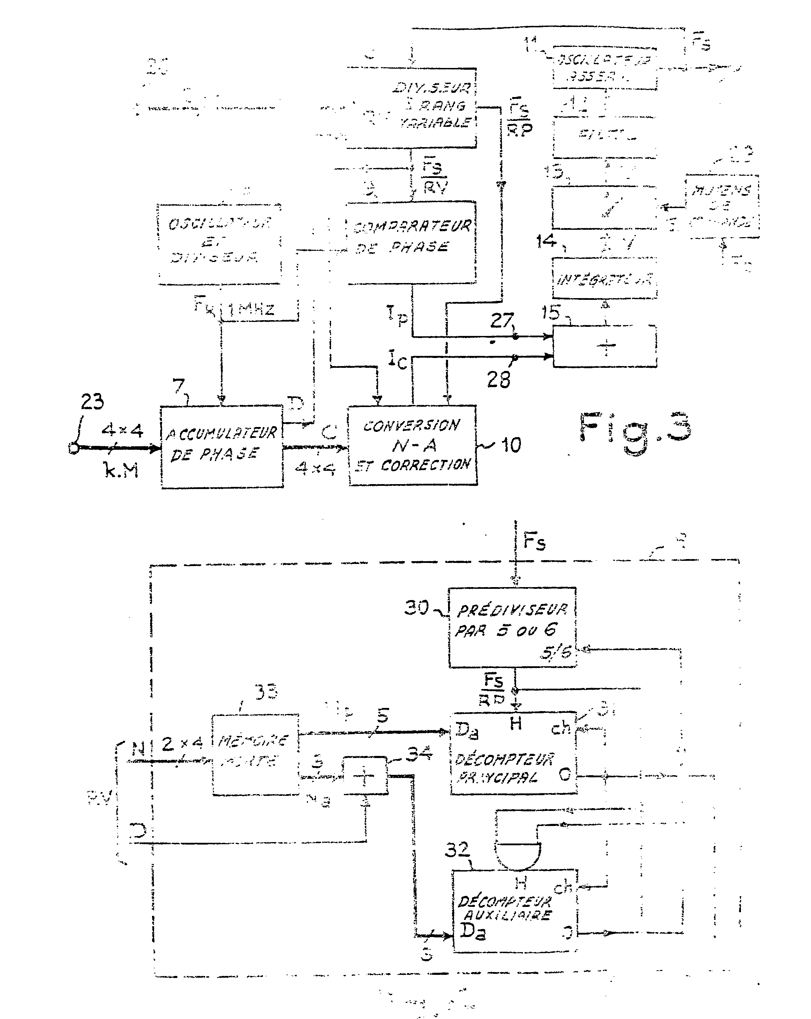

L'exemple de réalisation représenté sur la figure 3 comporte : un oscillateur asservi 11, un filtre 12, un échantillonneur-bloqueur 13, un intégrateur 14, un additionneur analogique 15, un diviseur 8 à rang variable, un comparateur de phase 9, un dispositif 10 de conversion numérique-analogique et de correction, un oscillateur et un diviseur 6, un dispositif 7 appelé accumulateur de phase, et des moyens 29 de commande de l'échantillonneur-bloqueur 13.

La fréquence synthétisée a pour valeur : $F_S = (N + k).F_R$, où N est un nombre entier, où k est compris entre 0 et 1, et où $F_R$ est la fréquence du signal de référence. Dans cet exemple $F_R$ est égale à 1 MHz. La valeur N est appliquée par une borne d'entrée 26 à une entrée du diviseur 8 à rang variable, sous la forme de deux chiffres décimaux codés en binaire. Une valeur k.M est appliquée par une borne d'entrée 23 à une entrée de l'accumulateur de phase 7, sous la forme de quatre chiffres décimaux codés en binaire. La valeur k.M est donc une valeur entière comprise entre 0 et M. M est la valeur du modulo de l'accumulateur de phase 7, qui est égal à 10 000 dans cet exemple.

Le pas de réglage de la fréquence synthétisée ne dépend que de la valeur du modulo M de l'accumulateur de phase 7, dans cet exemple le pas le plus fin correspond à 1/10 000 de la différence entre les valeurs $F_S$ de la fréquence synthétisée correspondant au rang N et au rang N + 1. Le diviseur 8 a un rang variable RV qui est égal soit à N, soit à N + 1, selon la valeur d'un signal logique D fourni par une sortie de l'accumulateur de phase 7, ce signal logique étant fourni lorsque le contenu de l'accumulateur de phase atteint ou dépasse sa valeur maximale qui est M = 10 000.

L'oscillateur asservi 11 possède une sortie fournissant un signal de fréquence $F_S$, qui est la fréquence synthétisée, d'une part à une entrée du diviseur 8 et d'autre part à une borne de sortie 16 du synthétiseur. Le diviseur 8 possède deux sorties fournissant deux signaux de fréquence $F_S$/RV et $F_S$/RP respectivement, à deux entrées du dispositif 10 de conversion numérique-analogique et de correction. D'autre part, le signal de fréquence $F_S$/RV est appliqué à une première entrée du comparateur de phase 9 et à une entrée des moyens de commande 29. Un oscillateur thermostaté 20 MHz et un diviseur de fréquence, 6, fournissent un signal de référence, de fréquence $F_R = 1$ MHz, à une seconde entrée du comparateur de phase 9 et à une entrée de l'accumulateur de phase 7. L'accumulateur de phase 7 possède une sortie multiple fournissant une valeur numérique C représentée par quatre chiffres décimaux codés en binaire, à une entrée du dispositif 10. Une sortie du comparateur de phase 9 fournit un courant d'intensité l$_P$ à une borne d'entrée 27 de l'additionneur 15. Une sortie du dispositif 10 fournit un courant d'intensité l$_q$ à une borne d'entrée 28 de l'additionneur 15.

La sortie de l'additionneur 15 fournit un courant à une entrée de l'intégrateur 14, celui-ci fournissant sur sa sortie une tension de valeur V. La sortie de l'intégrateur 14 est reliée à une entrée de l'échantillonneur-bloqueur 13 qui est commandé par un signal d'échantillonnage E généré par les moyens de commande 29, à partir du signal de référence. Une sortie de l'échantillonneur-bloqueur 13 est reliée à une entrée du filtre 12 pour lui fournir une tension V$_{ech}$. Une sortie du filtre 12 est reliée à une entrée de commande de l'oscillateur asservi 11.

L'intégrateur 14 réalise une intégration en fonction du temps, des charges apportées par les courants d'intensité l$_P$ et l$_C$. L'intégrateur 14 réalise aussi un changement de signe et fournit une tension V. Cette tension est échantillonnée par l'échantillonneur-bloqueur 13 à une fréquence égale à la fréquence $F_R$, mais avec un retard constant par rapport au signal de référence. La tension fournie par l'échantillonneur-bloqueur 13 est filtrée par le filtre 12 pour être lissée lors des périodes transitoires. En régime établi, les variations des quantités de charges apportées par les courants d'intensité l$_P$ et l$_q$ se compensent et la tension fournie à l'oscillateur asservi 11 est constante. Le comparateur de phase 9 fournit un signal qui est constitué par un courant dont le sens est négatif lorsque le signal fourni par le diviseur 8 est en retard par rapport au signal fourni par l'oscillateur et diviseur 6, et positif dans le cas contraire. L'amplitude de ce signal est constante, c'est une intensité de valeur l$_P$.

L'accumulateur de phase 7 accumule la valeur k.M à la fréquence $F_R$ et fournit la valeur cumulée au dispositif 10 qui fournit un courant d'intensité l$_q$ variable en fonction du temps d'une manière telle que la quantité de charges soit proportionnelle à la valeur C du contenu de l'accumulateur de phase 7 et à la valeur 1/$F_S$. D'autre part l'accumulateur de phase 7 fournit le signal D, quand son contenu atteint ou dépasse la valeur 10 000, afin d'augmenter d'une unité le rang de division du diviseur 8, ce rang est alors RV = N + 1.

La figure 4 représente un schéma synoptique du diviseur 8 à rang variable de cet exemple de réalisation. Il comporte un prédiviseur 30, un décompteur principal 31, un décompteur auxiliaire 32, une mémoire morte 33, et un additionneur 34. Le prédiviseur 30 est un compteur à deux modulo : 5 ou 6, possédant une entrée recevant le signal de fréquence $F_S$ fourni par la sortie de l'oscillateur asservi 11 ;

4

une entrée de commande 5/6 sélectionnant la valeur 5 ou la valeur 6 pour le rang de prédivision RP ; et une sortie fournissant un signal de fréquence $F_S/RP$.

Ce signal est fourni à une sortie du diviseur 8 et est appliqué à une entrée d'horloge H du décompteur principal 31 et à une entrée d'horloge H du décompteur auxiliaire 32, cette dernière étant validée par une entrée de validation d'horloge. Le décompteur principal 31 et le décompteur auxiliaire 32 possèdent chacun une entrée Da pour des données à charger dans ces décompteurs. L'entrée Da du décompteur principal 31 reçoit un mot binaire de cinq bits représentant un nombre entier $N_p$. L'entrée Da du décompteur auxiliaire 32 reçoit un mot binaire de trois bits fourni par la sortie de l'additionneur 34. L'additionneur 34 reçoit sur une première entrée un mot binaire de trois bits de valeur $N_a$, fourni par une sortie de la mémoire morte 33, et reçoit sur une seconde entrée le signal logique D fourni par l'accumulateur de phase 7. Une entrée d'adresse de la mémoire morte 33 reçoit la valeur N sous la forme de deux chiffres décimaux codés en binaire. La valeur N et la valeur du signal logique D déterminent la valeur RV du rang du diviseur 8. Quand le signal D a la valeur 1 l'additionneur 34 ajoute une unité à la valeur de Na.

Une sortie O du décompteur principal 31 est reliée à une entrée de commande de chargement ch de ce même décompteur principal 31, à une entrée de commande de chargement ch du décompteur auxiliaire 32, et à une sortie du diviseur 8. Cette sortie fournit le signal de fréquence $F_S/RV$. Une sortie O du décompteur auxiliaire 32 est reliée à l'entrée de validation d'horloge de ce même décompteur auxiliaire 32, et à l'entrée de commande 5/6 du prédiviseur 30, commandant la valeur RP du rang de prédivision. Cette sortie fournit le signal de fréquence $F_S/RP$.

Le prédiviseur 30 est réalisé en technologie ECL alors que les autres éléments du diviseur 8 sont réalisés en technologie TTL FAST (Fairchild Advanced Schottky TTL). Pendant chaque période du signal de fréquence $F_S/RV$, le prédiviseur 30 fonctionne pendant un premier intervalle de temps avec un rang de prédivision RP = 6 puis, pendant un second intervalle de temps, avec un rang de prédivision RP = 5. Au début de chacune de ces périodes, les décompteurs 31 et 32 sont chargés respectivement avec les valeurs $N_p$ et $N_a + D$, D prenant la valeur 0 ou 1. Pendant le premier intervalle de temps les décompteurs 31 et 32 décomptent à la fréquence $F_S/RP = F_S/6$. Le nombre $N_p$ étant toujours supérieur au nombre $N_a$, le décompteur auxiliaire 32 passe par la valeur 0 avant le décompteur principal 31. La sortie O du décompteur auxiliaire 32 fournit alors un signal bloquant l'entrée de validation d'horloge de ce même décompteur 32 et commandant le changement du rang de prédivision pour qu'il prenne la valeur 5. Pendant le second intervalle de temps, le décompteur principal 31 est seul à fonctionner. Il décompte jusqu'à ce que son contenu passe par la valeur 0, sa sortie O fournissant alors un signal qui provoque de nouveau un chargement des valeurs $N_p$ et $N_a + D$ respectivement dans les décompteurs 31 et 32, le cycle recommence alors.

Pendant chaque période le nombre d'impulsions, de fréquence $F_S$, reçues par le diviseur 8, est égal à :

$$RV = 6 \cdot (N_a + D) + 5 \cdot (N_p - N_a - D) = N_a + 5 \cdot N_p + D$$

Pour réaliser un synthétiseur couvrant les fréquences 100 à 150 MHz, avec une fréquence de référence $F_R = 1$ MHz, la mémoire morte 33 fournit des valeurs $N_p$ et $N_a$ qui sont les suivantes :

| $F_S$(MHz) | N | $N_p$ | $N_a$ |
|---|---|---|---|
| 100 | 100 | 20 | 0 |
| 101 | 101 | 20 | 1 |
| ... | ... | ... | ... |
| ... | ... | ... | ... |
| ... | ... | ... | ... |
| 149 | 149 | 29 | 4 |
| 150 | 150 | 30 | 0 |

Il est à noter que $N_a$ est toujours compris entre 0 et 4 inclus. Le premier intervalle de temps a donc une durée comprise entre 0 et $4 \times 6/F_S$ selon la valeur de $F_S$ à obtenir.

D'une façon générale, si n + 1 et n sont les deux valeurs successives du rang de prédivision RP, alors le rang du diviseur 8 est :

$$RV = (n + 1).N_a + (N_p - N_a).n, \text{ qui est encore égal à :}$$

$$RV = N_a + n.N_p$$

Pour que le dispositif diviseur à rang variable fonctionne, on montre qu'il est nécessaire que $N_p$ soit supérieur ou égal à $N_a$ et que $n^2 - n$ soit inférieur ou égal à la valeur minimum de RV.

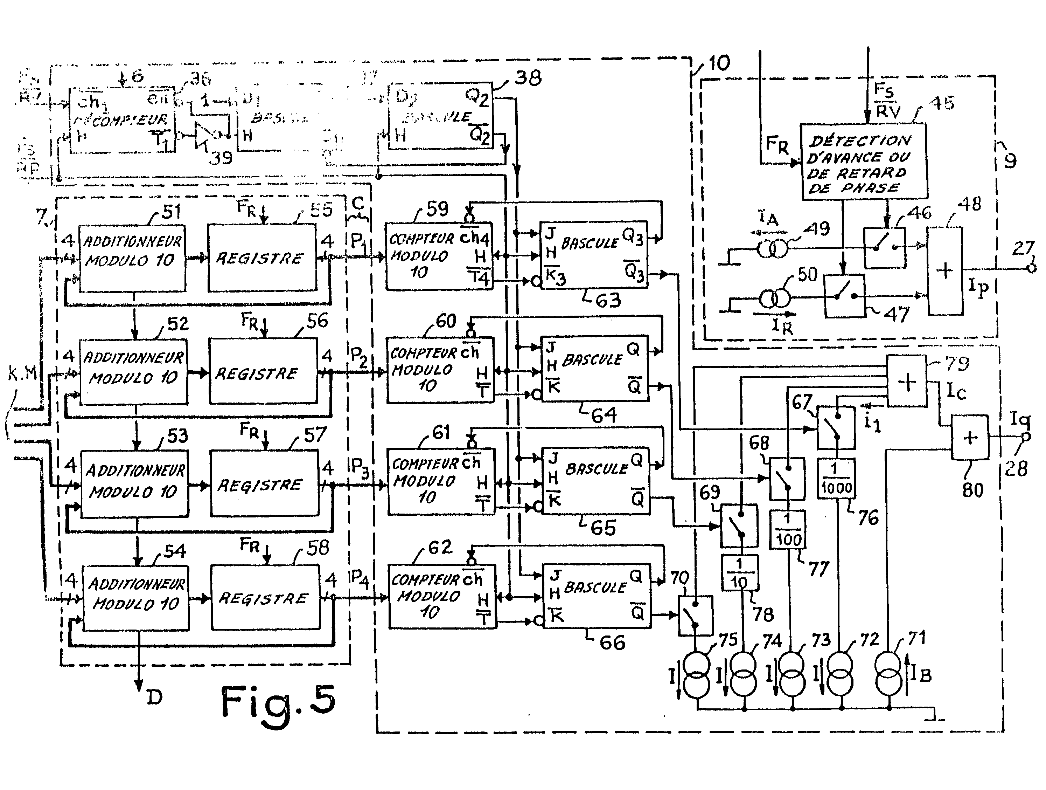

La figure 5 représente un schéma synoptique du comparateur de phase 9, de l'accumulateur de phase 7 et du dispositif 10 de conversion numérique-analogique et de correction. Le comparateur de phase 9 comporte un dispositif 45 de détection d'avance ou de retard de phase, deux commutateurs analogiques 46 et 47, deux sources de courant 49 et 50, et un additionneur analogique 48. Le comparateur de phase 9 possède deux entrées recevant respectivement le signal de référence, de fréquence $F_R$, et le signal fourni par la sortie du diviseur à rang variable 8, de fréquence $F_S/RV$, et ces entrées sont reliées respectivement à deux entrées du dispositif 45. Le dispositif 45 possède deux sorties fournissant respectivement deux signaux logiques aux entrées de commande des commutateurs 46 et 47. Les sources de courant 49 et 50 possèdent chacune une première borne reliée à un potentiel de référence et une seconde borne reliée à une entrée de l'additionneur analogique 48 par l'intermédiaire des commutateurs 46 et 47 respectivement. L'additionneur 48 possède une sortie qui constitue la sortie du comparateur de phase 9 et qui est reliée à la borne 27.

Le dispositif 45 est un dispositif numérique qui est constitué de deux bascules D, de technologie ECL, et dont la réalisation est à la portée de l'homme de l'art.

Lorsque le signal fourni par la sortie du diviseur à rang variable 8 est en avance de phase par rapport au signal de référence le dispositif 45 fournit un signal de commande fermant le commutateur 46 pour qu'il transmette le courant fourni par la source de courant 49, ce courant étant de signe négatif et d'intensité $I_A$. Lorsque le signal fourni par la sortie du diviseur à rang variable 8 est en retard par rapport au signal de référence le dispositif 45 fournit un signal de commande fermant le commutateur 47 pour qu'il transmette un courant fourni par la source de courant 50, courant de sens positif et d'intensité $I_R$. La durée de ces signaux est égale à l'intervalle de temps séparant un front montant du signal fourni par le diviseur à rang variable 8 et le front montant correspondant du signal de référence. Cette durée est donc proportionnelle à l'écart de phase entre ces deux signaux. La sortie de l'additionneur analogique 48 fournit un courant d'intensité $I_P$ qui est constitué par l'un de ces deux courants.

L'accumulateur de phase 7 est constitué de quatre additionneurs modulo 10 : 51, 52, 53, et 54 ; et de quatre registres : 55, 56, 57, et 58. Dans cet exemple, l'accumulateur de phase 7 a pour modulo $M = 10\,000$ et la valeur de l'incrément, appliqué à son entrée, est k.M exprimé par quatre chiffres décimaux codés en binaire. L'accumulateur de phase 7 comporte quatre accumulateurs recevant respectivement les quatre chiffres décimaux codés en binaire de l'incrément k.M. Ces quatre accumulateurs sont constitués respectivement de l'additionneur 51 et du registre 55, de l'additionneur 52 et du registre 56, de l'additionneur 53 et du registre 57, de l'additionneur 54 et du registre 58. Ces accumulateurs reçoivent les chiffres décimaux codés en binaire de poids croissant dans cet ordre. Chaque additionneur possède une sortie de retenue reliée à une entrée de retenue de l'additionneur suivant dans l'ordre 51, 52, 53, 54, et la sortie de retenue de l'additionneur 54 constitue la sortie de l'accumulateur de phase 7 fournissant le signal logique D qui commande le passage du rang du diviseur 8 de la valeur N à la valeur N + 1, lorsque le signal D a la valeur 1.

Chacun des additionneurs 51, 52, 53, 54, possède une première entrée recevant les quatre bits d'un des chiffres décimaux codés en binaire de l'incrément k.M ; une seconde entrée recevant quatre bits fournis par la sortie du registre associé : 55, 56, 57, 58 ; et une sortie fournissant quatre bits à une entrée du registre associé. Chaque registre 55 à 58 possède une entrée de commande recevant le signal de référence de fréquence $F_R$. Les quatre bits fournis respectivement par la sortie de chacun des registres 55 à 58 représentent respectivement des valeurs $P_1$, $P_2$, $P_3$, et $P_4$, des chiffres décimaux codés en binaire du nombre C fourni au dispositif 10.

Le synthétiseur selon l'invention est caractérisé par son dispositif 10 de conversion numérique-analogique et de correction, qui diffère des dispositifs connus mentionnés précédemment, et remédie à leurs inconvénients.

Le dispositif 10 comporte un dispositif de commande constitué par un décompteur 36, un inverseur logique 39, et deux bascules de type D : 37 et 38 ; quatre dispositifs de temporisation constitués de quatre compteurs modulo 10 : 59, 60, 61, et 62 ; et constitués de quatre bascules de type JK : 63, 64, 65, et 66 ; et comporte quatre commutateurs analogiques : 67, 68, 69, et 70 ; cinq sources de courant : 71, 72, 73, 74, et 75 ; trois diviseurs de courant : 76, 77, et 78 ; et deux additionneurs analogiques 79 et 80.

Les compteurs 59 à 62 sont associés respectivement aux bascules 63 à 66 et ils reçoivent respectivement les valeurs $P_1$, $P_2$, $P_3$ et $P_4$ sur des entrées de chargement de données. Par exemple, l'entrée de chargement de données du compteur 59 est reliée à la sortie du registre 55 pour recevoir la valeur $P_1$ ; une sortie $\overline{T_4}$ et une entrée $\overline{ch_4}$ du compteur 59 sont reliées respectivement à une entrée $\overline{K_3}$ et à une sortie $Q_3$ de la bascule 63. Chacun des compteurs 59 à 62 et chacune des bascules 63 à 66 possèdent une entrée d'horloge H recevant le signal de fréquence $F_S/RP$ fourni par la sortie du prédiviseur 30 du diviseur à rang variable 8. Chacune des bascules 63 à 66 possède une entrée J reliée à une sortie $Q_2$ de la bascule 38.

Chacune des bascules 63 à 66 possède une sortie inversée $\overline{Q}$ reliée à une entrée de commande de l'un des commutateurs 67 à 70, respectivement. Chacun de ces commutateurs transmet un courant fourni par une source de courant en série avec un diviseur de courant : le commutateur 67 transmet un courant $i_1$ fourni par la source de courant 72 et le diviseur de courant 76, de rapport 1/1 000. Le commutateur 68 transmet un courant fourni par la source de courant 73 en série avec le diviseur de courant 77, de rapport 1/100. Le commutateur 69 transmet le courant fourni par la source de courant 74 en série avec le diviseur de courant 78, de rapport 1/10. Le commutateur 70 transmet le courant fourni par la source de courant 75.

Les sources de courant 72 à 75 fournissent un courant de sens négatif et d'intensité identique I. Ils possèdent une borne commune reliée à un potentiel de référence. L'additionneur analogique 79 possède une sortie fournissant un courant d'intensité $I_C$ à une première entrée de l'additionneur analogique 80. Une seconde entrée de l'additionneur analogique 80 reçoit un courant d'intensité $I_B$ et de sens positif, dit courant de polarisation, fourni par une première borne de la source de courant 71. Une deuxième borne de la source de courant 71 est reliée au potentiel de référence. La sortie de l'additionneur 80 constitue la sortie du dispositif 10 et est reliée à la borne 28. Elle fournit le courant $I_q$.

Une entrée du dispositif 10, recevant le signal de fréquence $F_S/RV$ fourni par la sortie du diviseur à rang variable 8, est reliée à une entrée ch de commande de chargement du décompteur 36. Le décompteur 36 possède en outre une entrée de chargement de données recevant en permanence la valeur 6, une entrée d'horloge H recevant le signal de fréquence $F_S/RP$ fourni par la sortie du prédiviseur 30 du diviseur à rang variable 8, et une sortie $\overline{T_1}$ fournissant un signal logique de valeur 0 lorsque le contenu du décompteur 36 passe par la valeur 0. Cette sortie $\overline{T_1}$ est reliée à une entrée de validation $\overline{en}$ du compteur 36 et à une entrée d'horloge H de la bascule 37 par l'intermédiaire de l'inverseur logique 39.

La bascule 37 possède une entrée $D_1$ recevant en permanence une valeur 1, une entrée de remise à zéro $\overline{C_1}$ reliée à une sortie $\overline{Q_2}$ de la bascule 38, et une sortie $Q_1$ qui est reliée à une entrée $D_2$ de la bascule 38. La bascule 38 possède en outre une entrée d'horloge H recevant le signal de fréquence $F_S/RP$.

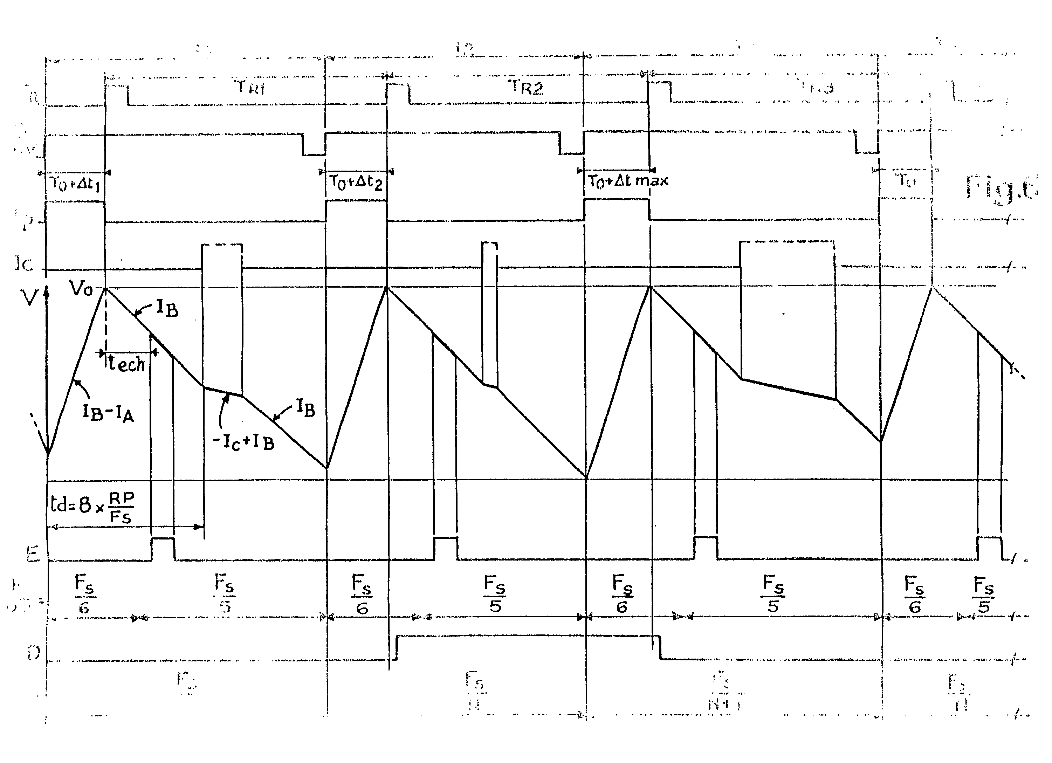

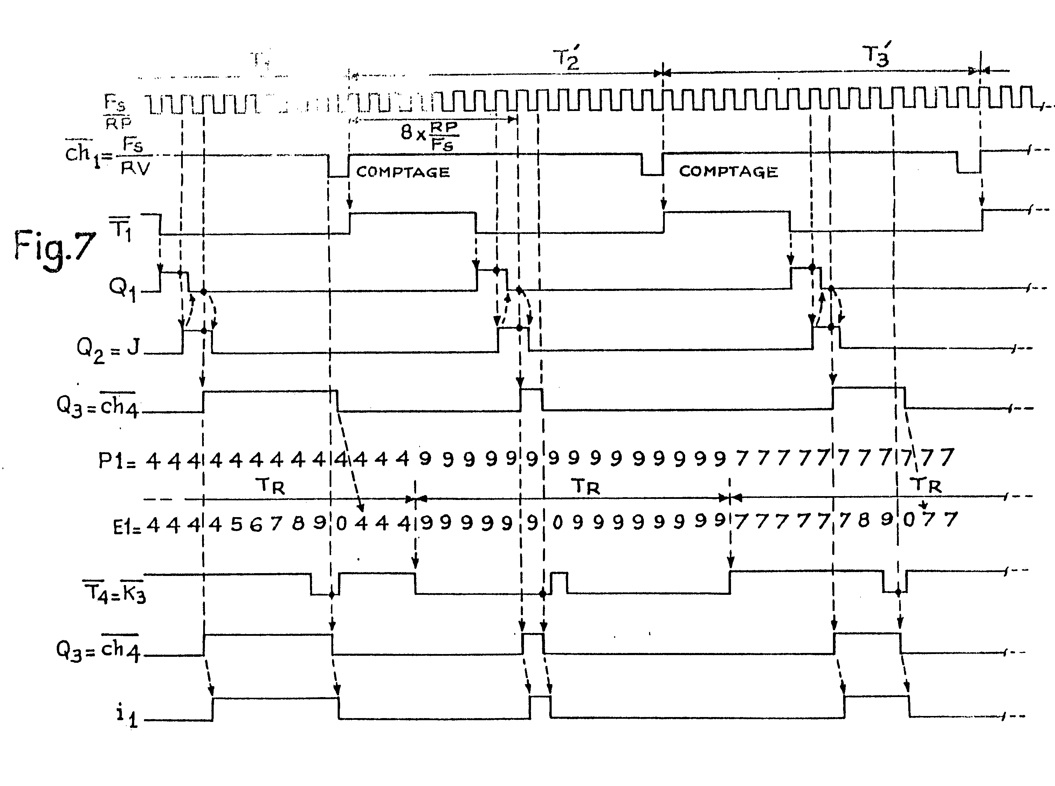

Les figures 6 et 7 représentent des chronogrammes des signaux mis en œuvre dans l'exemple de réalisation représenté sur la figure 5. La figure 6 représente ces diagrammes pendant quatre intervalles de temps $T_1$, $T_2$, $T_3$, et $T_4$ correspondant à quatre périodes du signal de fréquence $F_S/RV$ et à trois périodes $T_{R1}$, $T_{R2}$, $T_{R3}$ du signal de référence. Les impulsions du signal de référence, noté $F_R$, et les impulsions du signal fourni par la sortie du diviseur à rang variable 8, noté $F_S/RV$, sont décalées d'un temps variable respectivement égal à $T_0 + \Delta t_1$, $T_0 + \Delta t_2$, $T_0 + \Delta t_{max}$, et $T_0$. La valeur $T_0$ est une constante qui est égale à l'intervalle de temps séparant les impulsions lorsque le rang de division variable RV est égal à une valeur entière, comme c'est le cas lorsque la valeur k est nulle. La valeur $T_0$ correspond à une avance de phase, constante, qui est créé par le courant de polarisation d'intensité $I_B$ fourni par la source de courant 71. Cette avance de phase permet de faire fonctionner le comparateur de phase 9 dans une zone de fonctionnement ayant une meilleure linéarité, le fonctionnement au voisinage d'un écart de phase nul étant peu linéaire, et pouvant rajouter de la gigue de phase au signal fourni par l'oscillateur 11.

Pendant les intervalles de temps séparant les impulsions des signaux $F_R$ et $F_S/RV$ la sortie du comparateur de phase 9 fournit un courant de sens négatif et d'intensité $I_P = I_A$ constante ; et fournit un courant nul pendant le reste du temps. Pendant un régime transitoire, non représenté sur la figure 5, le courant d'intensité $I_P$ est constitué soit du courant positif $I_R$ fourni par la source de courant 50, soit du courant négatif et d'intensité $I_A$ fourni par la source de courant 49. Lorsque le régime est établi, ce qui correspond au cas représenté sur la figure 5, il y a toujours une avance de phase du signal $F_S/RV$ par rapport au signal $F_R$, dans cet exemple de réalisation. L'intensité $I_P$ est alors égale à $I_A$.

Le dispositif 10 de conversion numérique-analogique et de correction génère un courant d'intensité $I_q$ pour compenser, après intégration, les variations du courant d'intensité $I_P$ fourni par le comparateur de phase 9. Il est à noter que l'intégrateur 14 réalise aussi, par sa construction, une inversion de signe dont il faut tenir compte pour interpréter les variations de la tension de sortie V de cet intégrateur, représentée sur la figure 6. Le courant d'intensité $I_C$ a une durée variable et une amplitude variable en fonction du contenu C de l'accumulateur de phase 7 et en fonction de la fréquence synthétisée $F_S$.

Le courant d'intensité $I_C$ résulte de l'addition, par l'additionneur analogique 79, de quatre courants dont les intensités sont respectivement I/1 000, I/100, I/10, et I, transmis respectivement par les commutateurs 67 à 70 à partir d'un même instant, mais avec des durées différentes déterminées par le dispositif de temporisation constitué des compteurs 59 à 62 et des bascules 63 à 66. Ces compteurs et ces bascules ont pour fréquence d'horloge $F_S/RP$ avec RP = 5. Ce signal d'horloge est fourni par la sortie du prédiviseur 30 du diviseur à rang variable 8, après un certain intervalle de temps qui dépend de la valeur de la fréquence synthétisée $F_S$, car cet intervalle de temps est déterminé par la durée du décomptage de la valeur $N_a$ par le décompteur auxiliaire 32. $N_a + D$ pouvant prendre les valeurs 0 à 5 la sortie du prédiviseur 30 fournit un signal de fréquence $F_S/6$ pendant une durée au plus égale à $5 \times 6/F_S$. C'est pourquoi la génération du courant d'intensité $I_C$ est retardée d'une durée égale à $8 \times RP/F_S$ qui est donnée par le comptage de 6 impulsions plus le retard des bascules 37 et 38.

L'utilisation du prédiviseur 30 pour fournir le signal d'horloge des compteurs 59 à 62 permet de faire l'économie d'un diviseur indépendant, mais surtout a pour avantage pratique de fournir un signal mieux synchronisé par rapport au signal de sortie du diviseur 8, ce qui diminue la gigue de phase du signal synthétisé.

La réalisation de quatre sources de courants bien stabilisées et des quatre commutateurs correspondants est à la portée de l'homme de l'art. Elle est bien plus aisée que la réalisation d'un convertisseur numérique-analogique de $4 \times 4$ bits ayant un temps d'établissement d'environ 0,5 microseconde.

La réalisation du dispositif de temporisation, qui fonctionne à une fréquence d'horloge de l'ordre de 30 MHz, est elle aussi à la portée de l'homme de l'art. La durée maximale de la compensation est faible puisqu'elle est inférieure ou égale à 9 périodes de cette horloge, c'est-à-dire environ 0,3 microseconde. Ceci permet de choisir 1 microseconde pour période du signal de référence, d'où il découle la possibilité

7

de changer rapidement la valeur de la fréquence synthétisée, en vue d'applications telles que la surveillance radio panoramique, la transmission à sauts de fréquence, tout en obtenant une compensation précise et donc une faible gigue de phase.

Sur la figure 6, considérons l'évolution de la tension V fournie par la sortie de l'intégrateur 14, pendant l'intervalle de temps $T_1$. Pendant la durée $T_0 + \Delta t_1$ l'intégrateur 14 intègre un courant d'intensité $I_B - I_A$ correspondant au courant de polarisation et au courant traduisant l'avance de phase détectée par le comparateur de phase 9. L'intégration de ces courants provoque une augmentation de la tension V car $I_A$ est supérieure à $I_B$. Quand le courant $I_P$ fourni par la sortie du comparateur 9 redevient nul, seul le courant de polarisation $I_B$ est intégré. Ce courant étant de sens positif, et l'intégrateur 14 réalisant un changement de signe, la tension V est alors décroissante. Après une durée $t_d$ égale à $8 \times RP/F_S$, comptée à partir de l'impulsion du signal $F_S/RV$, le courant de compensation $I_C$ est généré, dans un sens antagoniste à celui du courant de polarisation, l'intégration du courant d'intensité $I_B - I_C$ provoque donc une décroissance plus lente de la tension V car $I_C$ est inférieure à $I_B$. Après la fin de l'intégration de ce courant $I_C$, seul le courant de polarisation d'intensité $I_B$ est intégré jusqu'à la fin de l'intervalle de durée $T_1$.

L'échantillonnage de la tension V est réalisé sous la commande d'un signal impulsionnel E de période égale à celle du signal de référence $F_R$, à des instants fixés, situés entre l'instant de fin du signal $I_P$ et le début du signal $I_C$ par un retard constant procuré par les moyens de commande 29 déclenchés par le signal $F_R$. La tension échantillonnée ainsi correspond donc à l'écart de phase subsistant après une compensation réalisée au moyen du courant d'intensité $I_C$, au cours de la période précédant la période $T_1$.

Après cet échantillonnage, commence une autre période du processus de compensation. Le courant $I_C$ généré pendant une partie de l'intervalle $T_1$ compense, dans l'intégrateur 14, la variation de charge causée par le courant $I_P$, de durée plus longue, généré au début de l'intervalle $T_2$. Le régime étant établi, la compensation est quasi parfaite, la tension V reprend quasiment la même valeur $V_0$ à la fin de chaque période du signal de référence, $T_{R1}$, $T_{R2}$, $T_{R3}$.

De même, la tension échantillonnée a une valeur quasi identique d'une période à la suivante. L'échantillonnage étant retardé d'un retard constant $t_{ech}$ par rapport au front montant du signal $F_R$, et le courant appliqué à l'intégrateur 14 étant d'intensité constante $I_B$, il y a une différence de valeur constante entre la tension $V_0$ et la tension échantillonnée.

Pendant les périodes $T_1$, $T_2$, $T_3$ l'avance de phase du signal $F_S/RV$ par rapport au signal $F_R$ croît constamment, mais pendant la période $T_2$ l'impulsion du signal de référence $F_R$ provoque le passage du contenu de l'accumulateur de phase 7 à sa valeur maximale M = 10 000, l'additionneur 54 fournit alors le signal logique D, de valeur 1, avec un certain retard. Le signal D est appliqué à la seconde entrée de l'additionneur 34 du diviseur à rang variable 8, où il provoque une augmentation d'une unité pour le rang variable RV du diviseur 8, cette variation du rang étant effective lors du prochain chargement des décompteurs 31 et 32, c'est-à-dire lors de la prochaine impulsion du signal $F_S/RV$. Pendant la période $T_3$ le rang de division RV du diviseur 8 étant plus important, l'avance de phase du signal $F_S/RV$ est réduite. Dans cet exemple, elle est égale à sa valeur statique au début de la période $T_4$. Le comptage dans l'accumulateur de phase 7 se poursuivant à la fréquence du signal de référence, le signal D repasse à la valeur 0 au cours de la période $T_3$.

Au fur et à mesure que l'avance de phase augmente, pendant les périodes $T_1$, $T_2$, $T_3$, la quantité de charges apportée par le courant de compensation $I_C$ diminue en valeur absolue, car la valeur C initialisant les compteurs 59 à 62 croît à chaque période $T_1$, $T_2$, $T_3$. Le courant $I_C$ a un sens tel, que la réduction de la quantité de charges qu'il fournit provoque une diminution de la tension V à la fin des périodes $T_1$, $T_2$, compte tenu de l'inversion de signe réalisée par l'intégrateur 14. Cette diminution de V permet de compenser l'augmentation V causée au début de la période suivante, $T_2$ et $T_3$ respectivement, par l'augmentation de la quantité de charges apportée par le courant $I_P$ dont la durée croît avec l'avance de phase.

Naturellement, lorsque l'avance de phase repasse par sa valeur statique, correspondant à l'écart de temps $T_0$, la valeur C fournie par l'accumulateur de phase 7 repasse par la valeur 0, c'est ce qui se passe au cours de la période $T_{R2}$. La quantité de charges apportée par le courant de compensation $I_C$ au cours de la période $T_3$ est alors maximale en valeur absolue, pour provoquer une augmentation de la tension V, qui compensera, à la fin de la période $T_{R3}$, la diminution de V provoquée par la diminution de la quantité de charges apportée par le courant $I_P$, dont la durée passe par sa valeur minimale $T_0$ à la fin de la période $T_{R3}$.

Le courant de compensation d'intensité $I_C$ est la somme des courants transmis par les commutateurs 67 à 70 sous l'action de quatre signaux logiques de commande qui sont générés d'une manière analogue pour chaque fraction du mot binaire représentant la valeur k.M. Ces courants diffèrent par leur valeur et par leur durée. Les commutateurs 67 à 70 transmettent respectivement des courants d'intensité I/1 000, I/100, I/10, et I. Le rapport entre deux valeurs consécutives de ces courants correspond au rapport des poids de deux mots binaires consécutifs représentant les valeurs $P_1$, $P_2$, $P_3$ et $P_4$.

Dans cet exemple de réalisation l'accumulateur de phase 7 reçoit une valeur k.M décimale codée en binaire et fournit une valeur C décimale codée en binaire, donc les valeurs $P_1$, $P_2$, $P_3$, et $P_4$ sont comprises chacune entre 0 et 9. Dans un autre mode de réalisation où l'accumulateur de phase 7 recevrait

8

une valeur codée en binaire sur 16 bits, il fournirait une valeur C codée en binaire sur 16 bits et celle-ci serait fractionnée en quatre mots binaires de 4 bits. Le poids de chacun de ces mots binaires étant 16, le rapport entre deux courants successifs serait alors fixé à 1/16.

D'autre part, les courants transmis par les commutateurs 66 à 70 ont une durée différente, proportionnelle respectivement aux valeurs $P_1$, $P_2$, $P_3$, et $P_4$. En outre, ces durées sont toutes proportionnelles à la période $1/F_S$ car les compteurs 59 à 62 ont pour fréquence d'horloge $F_S/RP$.

Considérons, par exemple, le courant $i_1$ qui est transmis par le commutateur 67, qui a une intensité égale à $I/1000$, et qui correspond à la valeur $P_1$ des quatre bits de poids le plus faible du mot binaire C fourni par l'accumulateur de phase 7. La durée de transmission du courant $i_1$ est déterminée par le compteur 59 et la bascule 63.

Les chronogrammes de la figure 7 illustrent la génération du courant $i_1$ pendant trois périodes : $T'_1$, $T'_2$, et $T'_3$ du signal, noté $F_S/RV$, fourni par le diviseur à rang variable 8. Quand le signal $F_S/RV$ est au niveau bas il commande le chargement de la valeur 6 dans le décompteur 36. Quand il passe au niveau haut il autorise le comptage du compteur 36. Le décompteur 36 fournit sur sa sortie $\overline{T_1}$ un signal de niveau 0 avec un retard de 6 périodes de durée $RP/F_S$, par rapport au front montant du signal $F_S/RV$. La sortie de l'inverseur 39 fournit alors un signal de niveau 1 à l'entrée $\overline{en}$ du décompteur 36, pour le bloquer jusqu'au prochain chargement. D'autre part, le passage au niveau 1 de ce signal logique déclenche la bascule 37.

La bascule 37 est une bascule de type D, dont l'entrée $D_1$ reçoit une valeur 1 en permanence. La sortie $Q_1$ fournit alors un signal logique de valeur 1 à l'entrée $D_2$ de la bascule 38. La bascule 38 est une bascule de type D, sa sortie $Q_2$ passe donc au niveau 1 lors de la prochaine impulsion du signal $F_S/RP$ qui constitue son signal d'horloge. Le signal logique de valeur 1 fourni par la sortie $Q_2$ est appliqué aux entrées J des bascules 63 à 66, afin que le prochain front du signal $F_S/RP$ provoque le passage à la valeur 1 du signal fourni par la sortie Q de ces bascules, et notamment la sortie $Q_3$ de la bascule 63, pour commencer le comptage déterminant la durée de chaque courant.

Sur chacun des compteurs 59 à 62 l'entrée de commande de chargement $\overline{ch}$, qui est une entrée avec inversion, reçoit un signal de valeur 1 qui permet donc de commencer un comptage simultanément dans chacun de ces compteurs. Le comptage, donc la génération du courant de compensation, commence avec un retard constant par rapport au front montant du signal $F_S/RV$, et ce retard est égal à $8 \times RV/F_S$. Quand la sortie $Q_2$ de la bascule 38 fournit un signal de valeur 1, la sortie $\overline{Q_2}$ fournit un signal de valeur 0 qui actionne l'entrée de remise à zéro $\overline{C_1}$ de la bascule 37. La remise à zéro de la bascule 37 provoque le retour à 0 du signal fourni par sa sortie $Q_1$. L'entrée $D_2$ de la bascule 38 recevant un signal de valeur 0, la prochaine impulsion du signal $F_S/RP$ provoque la remise à zéro de la bascule 38. Le signal de valeur 1 appliqué aux entrées J des bascules 63 à 66 ne dure donc que pendant la durée d'une période du signal $F_S/RP$, pour mettre la bascule 63 dans un état autorisant le compteur 59 à compter.

Après avoir été chargé avec la valeur $P_1$ le compteur 59 compte. Lorsque son contenu, noté $E_1$ sur la figure 6, atteint la valeur 9, la sortie $\overline{T_4}$ fournit un signal logique de valeur 0 qui est appliqué à l'entrée $\overline{K_3}$ de la bascule 63. La prochaine impulsion du signal d'horloge $F_S/RP$, est comptée par le compteur 59 comme une 10e impulsion, et par ailleurs elle provoque une remise à zéro de la bascule 63, le signal fourni par la sortie $Q_3$ reprenant la valeur 0 et provoquant le chargement dans le compteur 59 de la valeur $P_1$ présente à l'instant considéré sur l'entrée de chargement de données de ce compteur. Pour plus de clarté le retour à la valeur 0 du signal fourni par la sortie $Q_3$ est représenté sur l'avant-dernière ligne des chronogrammes représentés sur la figure 7.

Dans cet exemple, le signal fourni par la sortie avec inversion, $\overline{Q_3}$, de la bascule 63, est utilisé pour commander le commutateur 67. Le courant d'intensité $i_1$ transmis par le commutateur 67 a une durée correspondant approximativement à la durée pendant laquelle le signal fourni par la sortie $Q_3$ a pour valeur 1, les commutateurs ayant un certain retard à la fermeture et à l'ouverture.

A la fin de la période $T'_1$, la valeur $P_1$ fournie par la sortie de l'accumulateur de phase a pour valeur 9 dans cet exemple. La sortie $Q_3$ fournissant encore un signal de valeur 0, la valeur 9 est chargée dans le compteur 59. La valeur 9 étant égale à la valeur maximale que peut prendre le contenu du compteur 59 la sortie $\overline{T_4}$ fournit un signal de valeur 0 indiquant que le contenu du compteur 59 a sa valeur maximale.

Juste avant le début de la période $T'_2$, la valeur 0 du signal $F_S/RV$ provoque le chargement du décompteur 36 avec la valeur 6. Le décompteur 36 fournit sur sa sortie $\overline{T_1}$ un signal de valeur 0 retardé de 6 périodes de signal $F_S/RP$. Ce signal provoque le passage à la valeur 1 du signal fourni par la sortie $Q_1$ de la bascule 37, puis la prochaine impulsion du signal $F_S/RP$ provoque le passage à la valeur 1 du signal fourni par la sortie $Q_2$ de la bascule 38.

L'impulsion suivante du signal $F_S/RP$ provoque le passage à la valeur 1 de la sortie $Q_3$ de la bascule 63, le compteur 59 étant ainsi autorisé à compter. Le contenu du compteur 59 ayant déjà sa valeur maximale, la sortie $\overline{T_4}$ fournit un signal de valeur 0 qui est appliqué à l'entrée $\overline{K_3}$ de la bascule 63, alors que l'entrée J de cette bascule reçoit une valeur 0 car la sortie $Q_2$ de la bascule 38 est repassée à l'état 0 entre-temps. La bascule 63 étant alors remise à zéro par la prochaine impulsion du signal $F_S/RP$, le courant d'intensité $i_1$ est donc transmis pendant la durée d'une seule période du signal $F_S/RP$.

Pendant la période $T'_3$ le fonctionnement est analogue à celui des deux périodes précédentes. Au début de cette période la valeur $P_1$ fournie par la sortie de l'accumulateur de phase 7 est égale à 7. Lorsque le compteur 59 est autorisé à compter il compte trois impulsions du signal $F_S/RP$. Il est à

9

remarquer que, dans cet exemple de réalisation, la durée de passage du courant d'intensité $i_1$ est égale au complément à 10 de la valeur $P_1$ chargée dans le compteur 59, cette durée étant comptée en nombre de périodes du signal $F_S/RP$ : pendant la période $T'_1$, $P_1 = 4$, la durée du passage de $i_1$ est égale à six périodes ; pendant la période $T'_2$, $P_1 = 9$, la durée du passage de $i_1$ est égale à une période ; pendant la période $T'_3$, $P_1 = 7$, la durée du passage de $i_1$ est égale à trois périodes. Cette durée est donc une fonction linéaire décroissante de la valeur $P_1$ avec une durée minimale égale à une période du signal $F_S/RP$.

Le sens de variation s'explique par le sens du courant d'intensité $I_A$ et le sens des courants I, qui sont identiques dans cet exemple de réalisation. Le courant $I_A$, fourni par le comparateur de phase lorsqu'il y a une avance de phase, et le courant de compensation $I_C$ provoquent tous les deux une augmentation de V (figure 6). Pour obtenir un effet de compensation des variations de ces deux courants, il est donc nécessaire de réduire la durée du courant de compensation $I_C$ quand l'avance de phase augmente.

La durée minimale de la compensation, qui est égale à une période de signal $F_S/RP$ dans cet exemple, est destinée à éviter un problème de linéarité qui serait rencontré dans le cas où la valeur $P_1$ est égale à la valeur maximale, 9, du contenu du compteur 59 ; si le compteur 59 ne comptait pas une 10e impulsion la durée du courant $i_1$ serait rigoureusement nulle ce qui causerait une erreur de linéarité de la variation de durée du courant $i_1$ par rapport aux variations de $P_1$, parce qu'en pratique le commutateur 67 et la bascule 63 introduisent une constante dans la durée de transmission du courant $i_1$ chaque fois que cette durée n'est pas nulle, et cette constante serait absente dans les cas où la durée serait nulle.

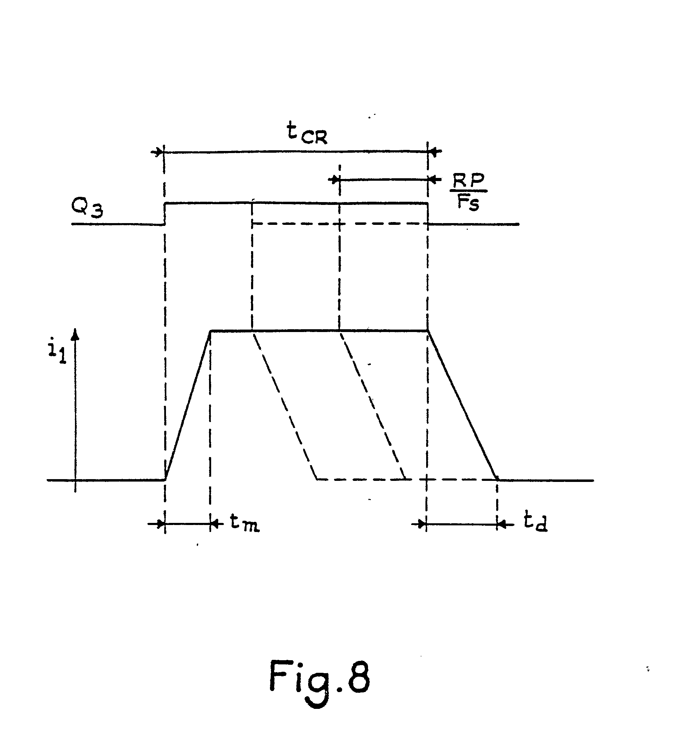

La figure 8 représente un chronogramme du signal fourni par la sortie $Q_3$ de la bascule 63 et du courant d'intensité $i_1$ correspondant. Le signal représenté en traits pleins correspond à une correction de durée $t_{CR}$ égale à trois périodes du signal $F_S/RP$ : le courant d'intensité $i_1$ n'atteint pas instantanément sa valeur nominale lorsque le signal fourni par la sortie $Q_3$ passe à la valeur 1 et, de même, il ne repasse pas instantanément à la valeur 0 lorsque la valeur fournie par la sortie $Q_3$ revient à la valeur 0. Il met un temps $t_m$ pour atteindre sa valeur nominale, et il met un temps $t_d$ pour revenir à une valeur nulle. Les temps $t_m$ et $t_d$ correspondent à des quantités de charges qui ne sont pas forcément égales et qui, donc, ajoutent une constante à la durée théorique de transmission du courant.

Sur la figure 8 sont représentés en pointillés le signal fourni par la sortie $Q_3$ et le courant d'intensité $i_1$ correspondant, pour des corrections durant une période ou deux périodes du signal $F_S/RP$. La constante rajoutée par le commutateur 67 à la durée de la correction est la même quelle que soit la durée de la correction, sauf si celle-ci était nulle car dans ce cas le commutateur 67 ne fonctionnerait pas du tout. C'est pourquoi, afin de maintenir une parfaite linéarité de la durée de la correction en fonction de la valeur fournie par l'accumulateur de phase, il est nécessaire d'ajouter une constante à la durée de la correction pour rendre celle-ci supérieure à la durée $t_m$. Dans cet exemple de réalisation le séquencement des signaux est tel que les compteurs 59 à 62 comptent une impulsion de plus que la valeur du complément à 9 de celle qui est chargée au début du comptage. Dans un autre exemple de réalisation une constante de valeur supérieure à une période peut être ajoutée systématiquement à la durée de chaque correction en utilisant des additionneurs placés entre les sorties de l'accumulateur de phase 7 et les entrées des compteurs 59 à 62, ou bien en utilisant des compteurs modulo 15 qui réalisent automatiquement un comptage supplémentaire de six impulsions avant de générer sur leur sortie $\overline{T}$ un signal de fin de comptage.

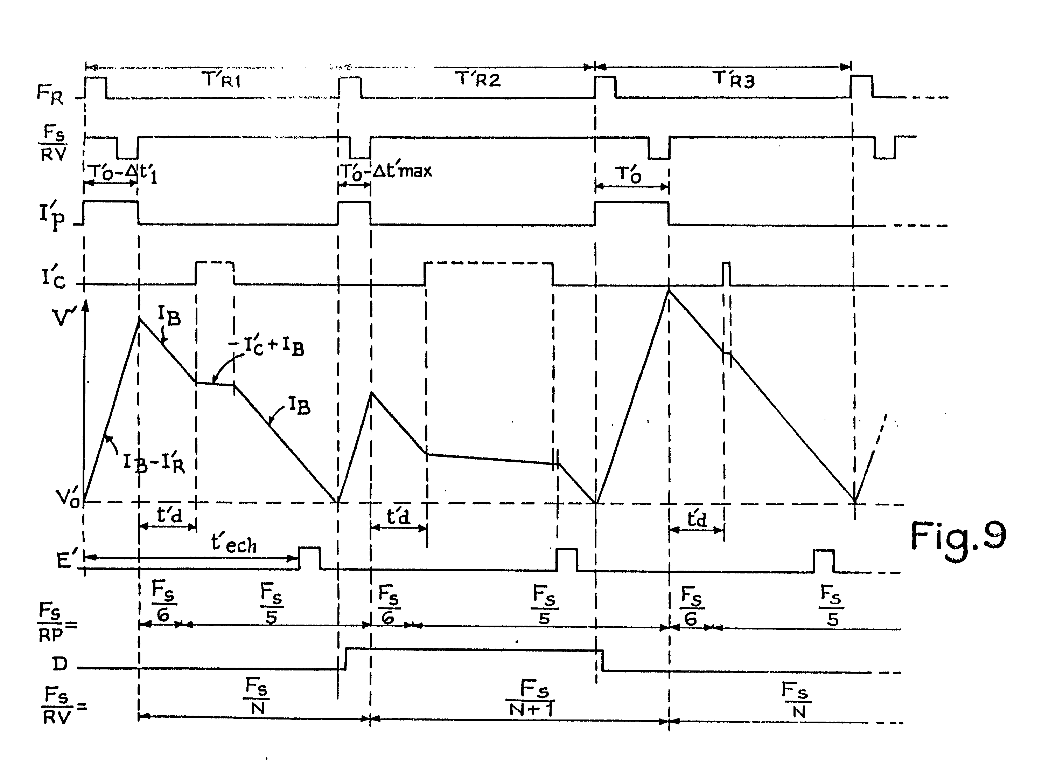

La figure 9 représente des chronogrammes illustrant le fonctionnement d'une variante du mode de réalisation décrit précédemment. Selon cette variante, en régime établi, le signal noté $F_S/RV$, fourni par la sortie du diviseur à rang variable 8, a un retard de phase par rapport au signal de référence, noté $F_R$.

Pendant des périodes successives $T'_{R1}$, $T'_{R2}$, $T'_{R3}$ du signal de référence, la durée de l'intervalle de temps séparant ce signal de référence et le signal, noté $F_S/RV$, fourni par le diviseur 8, a pour valeur $T'_0 - \Delta t'_1$, $T'_0 - \Delta t_{max}$, et $T'_0$ respectivement ; $T'_0$ respectivement ; $T'_0$ étant une constante. Le retard de phase augmente constamment, mais à certains instants il est ramené à sa valeur maximale, qui est sa valeur de départ, par une augmentation d'une unité de rang de division RV du diviseur 8.

Pendant l'intervalle de temps séparant un front montant du signal $F_R$ du front montant correspondant du signal $F_S/RV$, la sortie du comparateur de phase 9 fournit un courant d'intensité $I'_p$ constitué par le courant d'intensité $I'_R$ correspondant à un retard de phase. Le courant correspondant à un retard de phase, dans cette variante de réalisation, a un sens négatif contrairement au courant d'intensité $I_R$ de la précédente variante, le courant d'intensité $I_p$ fourni par le comparateur 9 a donc le même sens que dans la variante précédente.

L'intégrateur 14 reçoit un courant d'intensité $I_B - I'_R$ qui provoque une augmentation de la tension de sortie de l'intégrateur, V', car $I_R$ est supérieure à $I_B$. Le courant de polarisation a le même sens que dans la variante précédente et la même intensité $I_B$.

La compensation des variations de la quantité de charges apportée par le courant d'intensité $I'_p$ est réalisée avec un retard fixe $t'_d$, égal à $8 \times RP/F_S$ par rapport au front montant du signal $F_S/RV$, comme dans la variante précédente. Par contre, l'échantillonnage est commandé par un signal E' généré avec un retard $t'_{ech}$, par rapport au signal $F_R$, très supérieur au retard $t_{ech}$ de la variante précédente, car la compensation et l'échantillonnage correspondant sont réalisés pendant une même période du signal de référence : ainsi à la fin des périodes $T'_{R1}$, $T'_{R2}$, et $T'_{R3}$, la tension V retrouve une valeur pratiquement identique : $V'_0$. La valeur du retard $t'_{ech}$ est choisie telle que, dans tous les cas, l'échantillonnage a lieu après la fin de la compensation, et avant la fin de la période du signal $F_R$. Le début de la compensation est retardé d'un retard $t'd = 8 \times RP/F_S$ pour la même raison que dans la variante précédente, pour attendre la disponibilié du signal de fréquence $F_S/5$ fourni par la sortie du prédiviseur 30 du diviseur à rang variable 8.

Pendant les périodes $T'_{R1}$ et $T'_{R2}$ le retard de phase diminue, car le rang variable du diviseur 8 est égal à N.

Pendant les périodes $T'_{R1}$ et $T'_{R2}$ l'intervalle de temps séparant les impulsions du signal de référence et du signal $F_S/RV$, décroît, et passe par un minimum $T'_0 - \Delta t'_{max}$ au cours de la période $T'_{R2}$. Au cours de cette période le contenu C de l'accumulateur de phase 7 passe par la valeur 0, l'accumulateur 7 fournit un signal D de niveau 1 qui provoque le passage du rang de division à la valeur N + 1 pendant la période $T'_{R2}$. Dans cet exemple, le changement du rang de division ramène le retard de phase exactement à sa valeur maximale qui correspond à $T'_0$.

Pendant la période $T'_{R2}$ la tension V' passe par un maximum inférieur à celui où elle passe pendant la période $T'_{R1}$. Le courant de compensation d'intensité $I'_C$, qui est de même sens que le courant d'intensité $I'_R$ fourni par le comparateur 9, doit passer pendant un temps plus long pour que la tension V retrouve la valeur $V'_0$ à la fin de la période $T'_{R2}$. Selon cette variante, la durée du passage du courant de compensation varie donc dans le même sens que le contenu de l'accumulateur de phase 7. Les compteurs 59 à 62 sont remplacés par des décompteurs modulo 10 afin de compter un nombre de périodes, de durée $RP/F_S$, égal respectivement aux valeurs $P_1$, $P_2$, $P_3$, et $P_4$ fournies par l'accumulateur de phase 7, plus une unité pour éviter une erreur de non-linéarité lorsque $P_1$, ou $P_2$, ou $P_3$, ou $P_4$, est égal à 0. Les bascules 63 à 66 fonctionnent de manière analogue à celles de la variante précédente.

Au début de la période $T'_{R2}$ l'impulsion du signal $F_R$ provoque le passage du contenu de l'accumulateur de phase 7 à sa valeur maximale, le signal D prend la valeur 1 avec un certain retard dû au temps de propagation de la retenue dans les additionneurs 51 à 54, et provoque à la prochaine impulsion du signal $F_S/RV$ une augmentation d'une unité du rang de division RV. Cette augmentation du rang du diviseur 8 provoque une augmentation du retard de phase observable au début de la période $T'_{R3}$. La variation de la quantité de charges apportée par le courant $I'_P$ au début de la période $T'_{R3}$ est compensée par un raccourcissement de la durée du courant $I'_C$ de la compensation réalisée au cours de cette période $T'_{R3}$.

Le sens de commande de la fréquence de l'oscillateur asservi 11 doit être inversé par rapport à celui de la précédente variante.

Par rapport à cette dernière variante, la précédente variante présente un premier avantage qui est que l'échantillonnage peut être réalisé pendant l'intervalle de durée $t_d = t'd = 8 \times RP/F_S$. Pour les deux variantes, cette durée est obligatoirement choisie supérieure à $(n-1)$ périodes $RP/F_S$, si n est le plus petit modulo du prédiviseur 30, pour pouvoir disposer du signal d'horloge à la fréquence $F_S/n$ pour alimenter les entrées d'horloge des compteurs 59 à 62. Dans la précédente variante, l'intervalle de temps entre la fin du retard $t'_d$ et la fin de la période du signal de référence peut être entièrement utilisé pour la compensation, alors que dans la dernière variante cet intervalle est réduit de la durée occupée par l'échantillonnage. Cette différence n'est pas négligeable lorsque la période du signal de référence est très courte pour permettre des variations rapides de la fréquence synthétisée.

La précédente variante présente un second avantage qui est que le temps de propagation du signal de retenue D dans les additionneurs 51 à 54 n'est pas critique, contrairement au cas de la seconde variante. Le signal de retenue est déclenché par le signal $F_R$ et doit atteindre le niveau 1 avant l'impulsion du signal $F_S/RV$ de la même période de référence, $T_{R2}$ ou $T'_{R2}$, pour que le décompteur auxiliaire 32 soit chargé avec la valeur $N_a + 1$ sous l'action de cette impulsion. Dans le cas de la première variante, l'intervalle de temps disponible pour le passage du signal D au niveau 1, est beaucoup plus long.

Le synthétiseur selon l'invention peut être utilisé notamment comme oscillateur local dans les récepteurs radio de surveillance, nécessitant des variations rapides de fréquence, un pas fin, et une bonne pureté spectrale.

**Revendications**

1. Synthétiseur de fréquences à division fractionnaire, à faible gigue de phase, comportant :
— un oscillateur asservi (11) fournissant un signal de période $1/F_S$ ;
— un premier additionneur analogique (15) ayant une sortie couplée à une entrée de commande de l'oscillateur (11) ;
— un diviseur de fréquence (8) à rang variable RV, fournissant un signal de fréquence $F_S/RV$ ;
— des moyens (6) pour fournir un signal de référence ;
— un compteur modulo M (7), dit accumulateur de phase, fournissant un mot binaire C dont la valeur, modulo M, croît d'une valeur k.M à chaque période du signal de référence, k étant compris entre 0 et 1 ;
— un dispositif (10) de conversion numérique-analogique et de correction, couplant une première sortie de l'accumulateur de phase (7) à une première entrée du premier additionneur (15) ;
— un comparateur de phase (9) recevant le signal fourni par le diviseur (8) et le signal de référence, et fournissant à une seconde entrée du premier additionneur (15) un signal analogique dont la valeur est proportionnelle à l'écart de phase entre ces deux signaux et proportionnelle à la période $1/F_S$ ; caractérisé en ce que le dispositif (10) de conversion numérique-analogique et de correction, comporte :

— une pluralité de dispositifs de temporisation (59 à 66), chacun réalisant une temporisation de durée proportionnelle à la valeur d'une fraction déterminée du mot binaire C et proportionnelle à la période $1/F_S$ ;

— une pluralité de sources (72 à 78) fournissant chacune un signal analogique dont la valeur est constante et correspond respectivement au poids d'une des fractions du mot binaire C ;

— un second additionneur analogique (79) ayant une sortie couplée à la première entrée du premier additionneur analogique (15) ;

— une pluralité de commutateurs analogiques (67 à 70) reliant respectivement les sources (72 à 78) à des entrées du second additionneur (79) et étant commandées respectivement par les dispositifs de temporisation (59 à 66).

2. Synthétiseur selon la revendication 1, caractérisé en ce que le dispositif (10) de conversion numérique-analogique et de correction comporte en outre une source (71) couplée à une entrée du premier additionneur (15) et fournissant un signal analogique de valeur constante afin d'additionner une avance de phase constante, et non nulle, à l'écart de phase entre le signal fourni par l'oscillateur asservi (11) et le signal de référence ; en ce que le comparateur de phase (9) fournit un signal dont l'amplitude est fixée et dont la durée $T_0 + \Delta t$ est proportionnelle au décalage de phase entre le signal fourni par l'oscillateur asservi (11) et le signal de référence, et varie dans le même sens ; en ce que le dispositif (10) de conversion numérique-analogique et de correction comporte des moyens de commande (36, 37, 38), recevant le signal fourni par l'oscillateur asservi (11), pour déclencher tous les dispositifs de temporisation (59 à 66) avec un retard $t_d$ fixé, par rapport à ce dernier signal ; en ce que les dispositifs de temporisation (59 à 66) fournissent des signaux logiques dont la durée varie en sens inverse de la valeur des fractions du mot C ; et en ce que le synthétiseur comporte en outre des moyens (29) recevant le signal de référence, pour générer un signal E de commande de l'échantillonneur-bloqueur (13), de même fréquence que le signal de référence et retardé par rapport à celui-ci d'un retard constant $t_{ech}$ tel que chaque impulsion du signal E précède le déclenchement des dispositifs de temporisation (59 à 66), qui a lieu au cours de la même période du signal de référence.

3. Synthétiseur selon la revendication 1, caractérisé en ce que le dispositif (10) de conversion numérique-analogique et de correction comporte en outre une source (71) couplée à une entrée du premier additionneur (15) et fournissant un signal analogique de valeur constante afin d'additionner un retard de phase constant, et non nul, à l'écart de phase entre le signal fourni par l'oscillateur asservi (11) et le signal de référence ; en ce que le comparateur de phase (9) fournit un signal dont l'amplitude est fixée et dont la durée $T'_0 - \Delta t'$ est proportionnelle au décalage de phase entre le signal fourni par l'oscillateur asservi (11) et le signal de référence, et varie dans le même sens ; en ce que le dispositif (10) de conversion numérique-analogique et de correction comporte des moyens de commande (36, 37, 38), recevant le signal fourni par l'oscillateur asservi (11), pour déclencher tous les dispositifs de temporisation (59 à 66) avec un retard $t'_d$ fixé par rapport à ce dernier signal ; en ce que les dispositifs de temporisation (59 à 66) fournissent des signaux logiques dont la durée varie dans le même sens que la valeur des fractions du mot C ; et en ce que le synthétiseur comporte en outre des moyens (29) recevant le signal de référence, pour générer un signal E' de commande de l'échantillonneur-bloqueur (13), de même fréquence que le signal de référence, et retardé par rapport à celui-ci d'un retard constant $t'_{ech}$ tel que chaque impulsion du signal E' est postérieure aux instants où se terminent les signaux logiques fournis par les dispositifs de temporisation (59 à 62), au cours de la même période du signal de référence.

4. Synthétiseur selon la revendication 1, caractérisé en ce que le diviseur à rang variable (8) comporte un prédiviseur (30) à deux modulo ; et en ce que les dispositifs de temporisation (59 à 66) possèdent chacun une entrée d'horloge reliée à une sortie du prédiviseur (30) à deux modulo, et possèdent des moyens de commande (36, 37, 38) pour n'autoriser leur fonctionnement que pendant les intervalles de temps où le prédiviseur (30) fonctionne selon un modulo déterminé.

5. Synthétiseur selon la revendication 1, caractérisé en ce que chaque dispositif de temporisation (59 à 66) réalise une temporisation de durée fixée et non nulle, quand la fraction du mot C correspondant à ce dispositif a une valeur nulle ; cette durée étant au moins égale à la somme de la durée de mise en conduction et de la durée de mise hors conduction du commutateur (67 à 70) commandé par ce dispositif (59 à 66).

6. Utilisation d'un synthétiseur selon l'une des revendications 1 à 5, dans un récepteur de surveillance radioélectrique, balayant une gamme de fréquences.


**Claims**

1. Frequency synthesizer operating with fractional division and reduced phase jumping, comprising :
— a controlled oscillator (11) supplying a signal of the period $1/F_S$ ;
— a first analog adder (15) having an output coupled to a control input of the oscillator (11) ;
— a frequency divider (8) of variable order RV, supplying a signal of the frequency $F_S/RV$ ;

— means (6) for supplying a reference signal ;

— a modulo M counter (7), referred to as a phase accumulator, supplying a binary word C the value, modulo M, of which increases by a value kM at each period of the reference signal, k being comprised between 0 and 1 ;

— a device (10) for the digital-analog conversion and correction, coupling a first output of the phase accumulator (7) to a first input of the first adder (15) ;

— a phase comparator (9) receiving the signal supplied by the divider (8) and the reference signal, and supplying to a second input of the first adder (15) an analog signal the value of which is proportional to the phase difference between these two signals and proportional to the period $1/F_S$ ;

characterized in that the device (10) for the digital-analog conversion and correction comprises :

— a plurality of timing devices (59 to 66), each performng a timing of a duration which is proportional to the value of a determined fraction of the binary word C and proportional to the period $1/F_S$ ;

— a plurality of sources (70 to 78) each supplying an analog signal the value of which is constant and respectively corresponds to the rate of one of the fractions of the binary word C ;

— a second analog adder (79) having an output coupled to the first input of the first analog adder (15) ;

— a plurality of analog switches (67 to 70) respectively connecting the sources (70 to 78) to the inputs of the second adder (79) and being respectively controlled by the timing devices (59 to 66).

2. Synthesizer according to claim 1, characterized in that the device (10) for the digital-analog conversion and correction further comprises a source (71) coupled to an input of the first adder (15) and supplying an analog signal of constant value in order to add a constant non-zero phase advance to the phase difference between the signal supplied by the controlled oscillator (11) and the reference signal ; that the phase comparator (9) supplies a signal the amplitude of which is fixed and the duration $T_0 + \Delta t$ of which is proportional to the phase shift between the signal supplied by the controlled oscillator (11) and the reference signal, and varies in the same sense ; in that the device (10) for the digital-analog conversion and correction comprises control means (36, 37, 38) receiving the signal supplied by the controlled oscillator (11) for triggering all of the timing devices (59 to 66) with a fixed delay $t_d$ with respect to the latter signal ; in that the timing devices (59 to 66) supply logic signals the duration of which varies in the opposite sense of the value of the fractions of the word C ; and in that the synthesizer further comprises means (29) receiving the reference signal to generate a signal E for controlling a sample-and-hold member (13), having the same frequency as the reference signal and being delayed with respect to the latter by a constant delay $t_{ech}$ which is such that each pulse of the signal E precedes the triggering of the. timing devices (59 to 66) which occurs in the course of the same period of the reference signal.

3. Synthesizer according to claim 1, characterized in that the device (10) for the digital-analog conversion and correction further comprises a source (71) coupled to an input of the first adder (15) and supplying an analog signal of constant value in order to add a constant non-zero phase delay to the phase difference between the signal supplied by the controlled oscillator (11) and the reference signal ; in that the phase comparator (9) supplies a signal the amplitude of which is fixed and the duration $T'_0 + \Delta t'$ of which is proportional to the phase shift between the signal supplied by the controlled oscillator (11) and the reference signal, and varies in the same sense ; in that the device (10) for the digital-analog conversion and correction comprises control means (36, 37, 38) receiving the signal supplied by the controlled oscillator (11) for triggering all of the timing devices (59 to 66) with a delay $t'_d$ which is fixed with respect to the latter signal ; in that the timing devices (59 to 66) supply logic signals the duration of which varies in the same sense as the value of the fractions of the word C ; and in that the synthesizer further comprises means (29) receiving the reference signal to generate a signal E' for controlling the sample-and-hold member (13), having the same frequency as the reference signal and being delayed with respect to the latter by a constant delay $t'_{ech}$ which is such that each pulse of the signal E' occurs after the moments where the logic signals terminate which are supplied by the timing devices (59 to 62) in the course of the same period of the reference signal.

4. Synthesizer according to claim 1, characterized in that the variable order divider (8) comprises a prescaler (30) of two-modulo type ; in that the timing devices (59 to 66) each have a clock input connected to the output of the two-modulo type prescaler (30), and have control means (36, 37, 38) for enabling their operation only during time intervals where the prescaler (30) operates according to a determined modulo.

5. Synthesizer according to claim 1, characterized in that each timing device (59 to 66) performs a timing of fixed non-zero duration when the fraction of the word C corresponding to this device has a zero value ; this duration being at least equal to the sum of the duration of conduction and the duration of non-conduction of the switch (67 to 70) controlled by this device (59 to 66).

6. Use of a synthesizer according to any of claims 1 to 5 in a radio-electric monitoring receiver scanning a frequency band.

**Patentansprüche**

1. Frequenzsyntheseschaltung, die mit Teilung durch Bruchzahlen arbeitet und mit geringen Phasensprüngen behaftet ist, enthaltend :

— einen geregelten Oszillator (11), der ein Signal der Periode $1/F_S$ liefert ;

— einen ersten analogen Addierer (15), der einen Ausgang aufweist, welcher an einen Steuereingang des Oszillators (11) angekoppelt ist ;

— einen Frequenzteiler (8) mit variabler Ordnungszahl RV, welcher ein Signal der Frequenz $F_S/RV$ liefert ;

— Mittel (6) zum Liefern eines Referenzsignals ;

— einen Zähler Modulo M (7), der als Phasenakkumulator bezeichnet wird und ein Binärwort C ausgibt, dessen Wert Modulo M bei jeder Periode des Referenzsignals um einen Wert k.M ansteigt, worin k zwischen 0 und 1 liegt ;

— eine Vorrichtung (10) zur Digital/Analog-Umsetzung und Korrektur, welche einen ersten Ausgang des Phasenakkumulators (7) mit einem ersten Eingang des ersten Addierers (15) koppelt ;

— einen Phasenkomparator (9), der das von dem Teiler (8) gelieferte Signal und das Referenzsignal empfängt sowie an einen zweiten Eingang des ersten Addierers (15) ein analoges Signal liefert, dessen Wert proportional zur Phasendifferenz zwischen diesen zwei Signalen und proportional zur Periode $1/F_S$ ist ;

dadurch gekennzeichnet, daß die vorrichtung (10) zur Digital/Analog-Umsetzung und Korrektur umfaßt :

— eine Mehrzahl von Zeitsteuervorrichtungen (59 bis 66), die jeweils eine Zeitspanne bestimmen, welche proportional zu dem Wert eines vorbestimmten Bruchteils des Binärwortes C und proportional zur Periode $1/F_S$ ist ;

— eine Mehrzahl von Quellen (72 bis 78), die jeweils ein analoges Signal liefern, dessen Wert konstant ist und jeweils der Wertigkeit eines Bruchteils des Binärwortes C entsprechen ;

— einen zweiten analogen Addierer (79), der einen Ausgang aufweist, welcher an den ersten Eingang des ersten analogen Addierers (15) angekoppelt ist ;

— eine Mehrzahl von analogen Schaltern (67 bis 70), welche jeweils die Quellen (72 bis 78) mit Eingängen des zweiten Addierers (79) verbinden und jeweils durch die Zeitsteuervorrichtungen (59 bis 66) gesteuert sind.

2. Syntheseschaltung nach Anspruch 1, dadurch gekennzeichnet, daß die Vorrichtung (10) zur Digital/Analog-Umsetzung und Korrektur ferner eine Quelle (71) umfaßt, die an einen Eingang des ersten Addierers (15) angekoppelt ist und ein analoges Signal liefert, dessen Wert konstant ist, um eine konstante und nicht verschwindende Phasenvoreilung zwischen der Phasendifferenz zwischen dem vom geregelten Oszillator (11) gelieferten Signal und dem Referenzsignal hinzuzuaddieren ; daß der Phasenkomparator (9) ein Signal liefert, dessen Amplitude festliegt und dessen Dauer $T_0 + \Delta t$ proportional zur Phasenverschiebung zwischen dem vom geregelten Oszillator (11) gelieferten Signal und dem Referenzsignal ist und sich in gleichem Sinne ändert ; daß die Vorrichtung (10) zur Analog/Digital-Umsetzung und Korrektur Steuermittel (36, 37, 38) umfaßt, welche das von dem geregelten Oszillator (11) gelieferte Signal empfangen, um alle Zeitsteuervorrichtungen (59 bis 66) mit einer Verzögerung $t_d$ auszulösen, welche in bezug auf letzteres Signal festgelegt ist ; daß die Zeitsteuervorrichtungen (59 bis 66) Logiksignale liefern, deren Dauer sich im umgekehrten Sinne des Werts der Bruchteile des Wortes C ändern ; und daß die Syntheseschaltung ferner Mittel (59) enthält, welche das Referenzsignal empfangen, um ein Signal E zur Steuerung einer Abtast- und Halteeinrichtung (13) zu erzeugen, das dieselbe Frequenz wie das Referenzsignal besitzt und gegenüber diesem um eine konstante Verzögerung $t_{ech}$ verzögert ist, die so bemessen ist, daß jeder Impuls des Signals E der Auslösung der Zeitsteuervorrichtungern (59 bis 66) vorausgeht, welche im Verlauf derselben Periode des Referenzsignals stattfindet.

3. Syntheseschaltung nach Anspruch 1, dadurch gekennzeichnet, daß die Vorrichtung (10) zur Digital/Analog-Umsetzung und Korrektur weiterhin eine Quelle (71) umfaßt, die an einen Eingang des ersten Addierers (15) angekoppelt ist und ein analoges Signal von konstantem Wert liefert, um eine konstante Phasenverzögerung, die nicht gleich Null ist, zur Phasendifferenz zwischen dem vom geregelten Oszillator (11) gelieferten Signal und dem Referenzsignal hinzuzuaddieren ; daß der Phasenkomparator (9) ein Signal liefert, dessen Amplitude fest ist und dessen Dauer $T'_0 + \Delta t'$ proportional zur Phasenverschiebung zwischen dem vom geregelten Oszillator (11) gelieferten Signal und dem Referenzsignal ist und sich in gleichem Sinne ändert ; daß die Vorrichtung (10) zur Digital/Analog-Umsetzung und Korrektur Steuermittel (36, 37, 38) umfaßt, welche das von dem geregelten Oszillator (11) gelieferte Signal empfangen, um alle Zeitsteuervorrichtungen (59 bis 66) mit einer Verzögerung $t'_d$ auszulösen, welche in bezug auf dieses letztere Signal festliegt ; daß die Zeitsteuervorrichtungen (59 bis 66) Logiksignale liefern, deren Dauer sich in gleichem Sinne wie der Wert der Bruchteile des Wortes C ändert ; und daß die Syntheseschaltung ferner Mittel (29) umfaßt, die das Referenzsignal empfangen, um ein Signal E' zur Steuerung einer Abtast- und Halteeinrichtung (13) zu erzeugen, das dieselbe Frequenz wie das Referenzsignal aufweist und bezüglich diesem eine konstante Verzögerung $t'_{ech}$ aufweist, die so bemessen ist, daß jeder Impuls des Signals E' später als die Zeitpunkte auftritt, zu welchen die Logiksignale enden, die von den Zeitsteuervorrichtungern (59 bis 62) im Verlauf derselben Periode des Referenzsignals geliefert werden.

4. Syntheseschaltung nach Anspruch 1, dadurch gekennzeichnet, daß der Teiler mit variabler Ordnungszahl (8) einen Zweifach-Modulo-Vorteiler (30) enthält und daß die Zeitsteuervorrichtungen (59 bis 66) jeweils einen Takteingang aufweisen, der an einen Ausgang des Zweifach-Modulo-Verteilers (30) angeschlossen ist, und Steuermittel (36, 37, 38) besitzen, um ihre Funktion nur während der Zeitintervalle freizugeben, in welchen der Vorteiler (30) mit einem bestimmten Modulo arbeitet.

5. Syntheseschaltung nach Anspruch 1, dadurch gekennzeichnet, daß jede Zeitsteuervorrichtung (59 bis 66) eine Zeitsteuerung von fester und nicht verschwindender Dauer vornimmt, wenn der Bruchteil des Wortes C, das dieser Vorrichtung entspricht, einen verschwindenden Wert aufweist ; wobei diese Dauer wenigstens gleich der Summe der Dauer der Leitendsteuerung und der Dauer der Nichtleitendsteuerung des durch diese Vorrichtung (59 bis 66) gesteuerten Schalters (67 bis 79) ist.

6. Verwendung einer Syntheseschaltung nach einem der Ansprüche 1 bis 5 in einem Empfänger zur Funküberwachung, der ein Frequenzband abtastet.

0 147 307

Fig.1a

$I_{C1}$

$I_1 = k_0 \times C_2$

t

$k_1 \times \dfrac{1}{F_s}$

Fig.1b

$I_{C2}$

$I_2$

t

$C_2 \times k_2 \times \dfrac{1}{F_s}$

$I_{C31}$

$I$

Fig.2a

t

$P_3 \times \dfrac{k_3}{F_s}$

Fig.2b

$I_{C32}$

$\dfrac{I}{10}$

t

$P_2 \times \dfrac{k_3}{F_s}$

Fig.2c

$I_{C33}$

$\dfrac{I}{100}$

t

$P_1 \times \dfrac{k_3}{F_s}$

$I_{C3}$

Fig.2 d

t

$P_2 \times \dfrac{k_3}{F_s}$

Fig.3

Fig. 5

0 147 307

Fig.6

$T_{R1}$

$T_{R2}$

$T_{R3}$

$T_0+\Delta t_1$

$T_0+\Delta t_2$

$T_0+\Delta t\ max$

$T_0$

Ic

V  Vo

$I_B$

$t_{ech}$

$I_B-I_A$

$-I_C+I_B$

$I_B$

$td=8\times\dfrac{RP}{Fs}$

$\dfrac{F_s}{6}$  $\dfrac{F_s}{5}$  $\dfrac{F_s}{6}$  $\dfrac{F_s}{5}$  $\dfrac{F_s}{6}$  $\dfrac{F_s}{5}$  $\dfrac{F_s}{6}$  $\dfrac{F_s}{5}$

0 147 307

Fig.7

0 147 307

Fig.8

Fig.9

0 147 307